# EUROPEAN PATENT APPLICATION

(11) **EP 2 613 561 A1**
(43) Date of publication of application: **10.07.2013**
(21) Application number: 12159059.0
(22) Date of filing: 12.03.2012
(51) Int. Cl.: H04R 1/06, H04R 17/00, H01L 41/047, H01L 41/053

(54) **Vibration Speaker**

(30) Priority: 05.01.2012 TW 101100522
(71) Applicant: Chief Land Electronic Co. Ltd., Wugu Dist., New Taipei City 248 (TW)
(72) Inventor: Ching, Chia-Nan, 32097 Zhongli City, Taoyuan County (TW); Chen, Chien-Chang, 320 Zhongli City, Taoyuan County (TW); Yen, Chien-Hsuan, 221 New Taipei City (TW)
(74) Representative: Karakatsanis, Georgios

(57) **Abstract**

A vibration speaker includes a top cover, a bottom cover, at least one transducer plate and at least one conductive connector. The top cover and the bottom cover define a space to accommodate the transducer plate and the conductive connector. Each transducer plate includes a conductive plate, a first smart material layer coated on a first surface of the conductive plate, and a first electrode layer formed on the first smart material layer. The conductive connector presses on the transducer plate, wherein an insulating layer is coated on an area between the first surface and the conductive connector but excluding the first electrode layer, such that the conductive connector electrically contacts the first electrode layer but is insulated from the conductive plate.

## Description

### BACKGROUND OF THE INVENTION

### 1. FIELD OF THE INVENTION

The present invention generally relates to a vibration speaker, and more particularly to a piezoelectric vibration speaker.

### 2. DESCRIPTION OF RELATED ART

A speaker (or "loudspeaker") is an energy transducer that transforms an electrical signal to mechanical vibration. A conventional moving-coil speaker is made up of a magnet, a voice coil, a flexible support and a sound releasing hole. In operation, the electrical signal is transferred to the voice coil, which produces electromagnetic induction, therefore generating an induced current. The induced current energizes the flexible support, and sound is thus produced via the sound releasing hole. In spite of the fact that the conventional moving-coil speaker has been fully developed, it nevertheless occupies large volume, consumes great power and is liable to magnetic field. Therefore, the conventional moving-coil speaker is not adaptable to miniaturization or portability for electronic devices

Therefore, a need has arisen to propose a novel vibration speaker to overcome the drawbacks discussed above.

### SUMMARY OF THE INVENTION

In view of the foregoing, the embodiment of the present invention provides a vibration speaker that advantageously occupies small volume, consumes little power, and has a simplified architecture to facilitate easy assembling.

According to one embodiment, a vibration speaker includes a top cover, a bottom cover, at least one transducer plate and at least one conductive connector. The top cover and the bottom cover define a space. The transducer plate is disposed in the defined space, wherein each of the transducer plate includes a conductive plate, a first smart material layer coated on a first surface of the conductive plate, and a first electrode layer formed on the first smart material layer. The conductive connector presses on the transducer plate, wherein an insulating layer is coated on an area between the first surface and the conductive connector but excluding the first electrode layer, such that the conductive connector electrically contacts the first electrode layer but is insulated from the conductive plate.

### BRIEF DESCRIPTION OF THE DRAWINGS

FIG. 1A shows a schematic diagram illustrative of a vibration speaker according to a first embodiment of the present invention;
FIG. 1B shows a disassembled vibration module according to the first embodiment of the present invention;
FIG. 1C shows a cross-sectional view of a unimorph transducer according to the first embodiment of the present invention;
FIG. 1D shows a perspective view of the unimorph transducer according to the first embodiment of the present invention;
FIG. 1E shows a perspective view of the conductive connector according to the first embodiment of the present invention;
FIG. 1F shows a perspective view of a bottom surface of the top cover according to the first embodiment of the present invention;
FIG. 1G shows a perspective view of another conductive connector according to the first embodiment of the present invention;
FIG. 2A to FIG. 2D show perspective views of some conductive rings;
FIG. 2E to FIG. 2G shows perspective views of some conductive third alignment pins;
FIG. 3A shows a disassembled vibration module according to a second embodiment of the present invention;
FIG. 3B shows a cross-sectional view of the bimorph transducer according to the second embodiment of the present invention;
FIG. 4 shows a perspective view of a disassembled vibration module according to a third embodiment of the present invention;
FIG. 5A shows a perspective view of a disassembled vibration module according to a fourth embodiment of the present invention;
FIG. 5B shows a perspective view of a conductive connector according to the fourth embodiment of the present invention;
FIG. 5C shows a perspective view of another conductive connector according to the fourth embodiment of the present invention; and
FIG. 6 shows a perspective view of a vibration module that combines two embodiments.

### DETAILED DESCRIPTION OF THE INVENTION

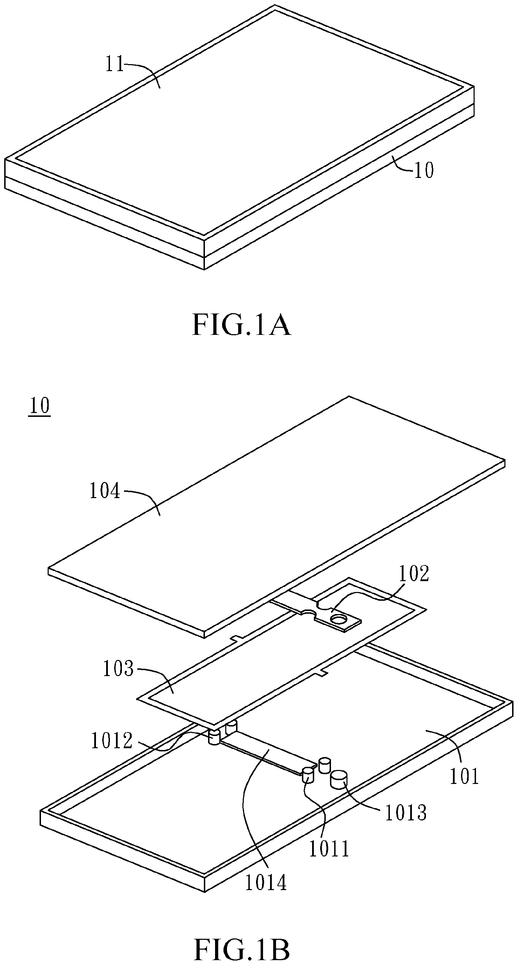

FIG. 1A shows a schematic diagram illustrative of a vibration speaker according to a first embodiment of the present invention. In the embodiment, the vibration speaker includes a vibration module 10 and a driving module 11. The driving module 11 may drive the vibration module 10, for example, via a conductive wire (not shown). When the vibration module 10 is in contact with a vibration plate (not shown), mechanical vibration energy generated by the vibration module 10 is propagated to the vibration plate, therefore producing sound perceivable by a user. The vibration module 10 and the driving module 10 of the embodiment may have their shapes modified and their relative positions adjusted in accordance with a specific application.

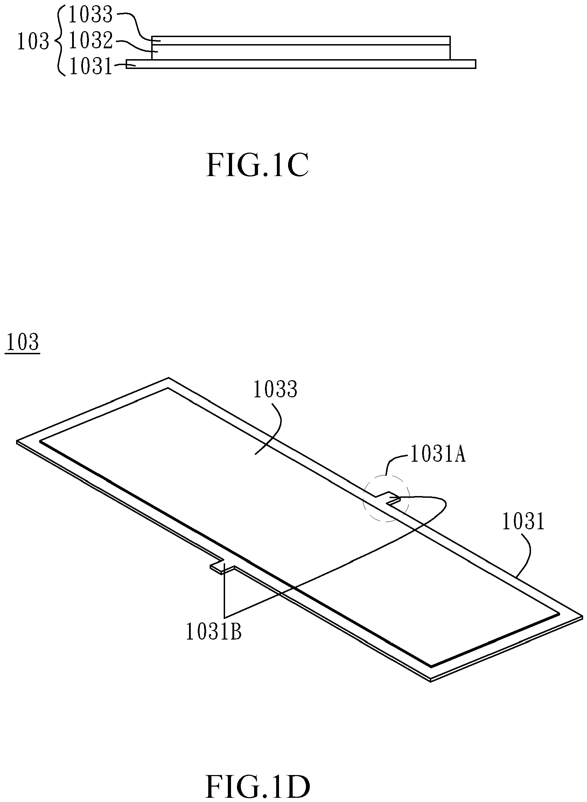

FIG. 1B shows a disassembled vibration module 10 according to the first embodiment of the present invention. The vibration module 10 includes a bottom cover 101, at least one conductive connector 102, at least one transducer plate 103 and a top cover 104. The bottom cover 101 and the top cover 104 define a space to accommodate the conductive connector 102 and the transducer plate 103. The transducer plate 103 of the embodiment includes a unimorph transducer having a cross-sectional view shown in FIG. 1C, and a perspective view shown in FIG. 1D. The transducer plate 103 of the embodiment includes a conductive plate 1031, a first smart material layer 1032 coated on a first (top) surface of the conductive plate 1031, and a first electrode layer 1033 formed on the first smart material layer 1032. The first smart material layer 1032 may be made up of a smart material, which includes a piezoelectric material, an electro-active polymer (EAP), a shape memory alloy (SMA), a magnetostrictive material or an electrostrictive material.

As shown in FIG. 1B, the conductive connector 102 presses on the transducer plate 103. An insulating layer (e.g., insulating varnish) is coated on an area 1031A between the first (top) surface of the conductive plate 1031 and the conductive connector 102 but excluding the first electrode layer 1033, such that the conductive connector 102 electrically contacts the first electrode layer 1033 but is insulated from the conductive plate 1031. The driving module 11 drives the transducer plate 103 by electrically connecting, via conductive wires, the conductive connector 102 and the conductive plate 1031, respectively.

Still referring to FIG. 1B, the bottom cover 101 includes two first alignment pins 1011 contacting one end of the transducer plate 103; and the bottom cover 101 also includes two second alignment pins 1012 contacting another end of the transducer plate 103. The first alignment pins 1011 are opposite to the second alignment pins 1012.

As shown in FIG. 1D, the transducer plate 103 of the embedment includes at least one ledge 1031B extended from a center of one side of the transducer plate 103. The ledge 1031 B is held between the two first alignment pins 1011, or between the two second alignment pins 1012.

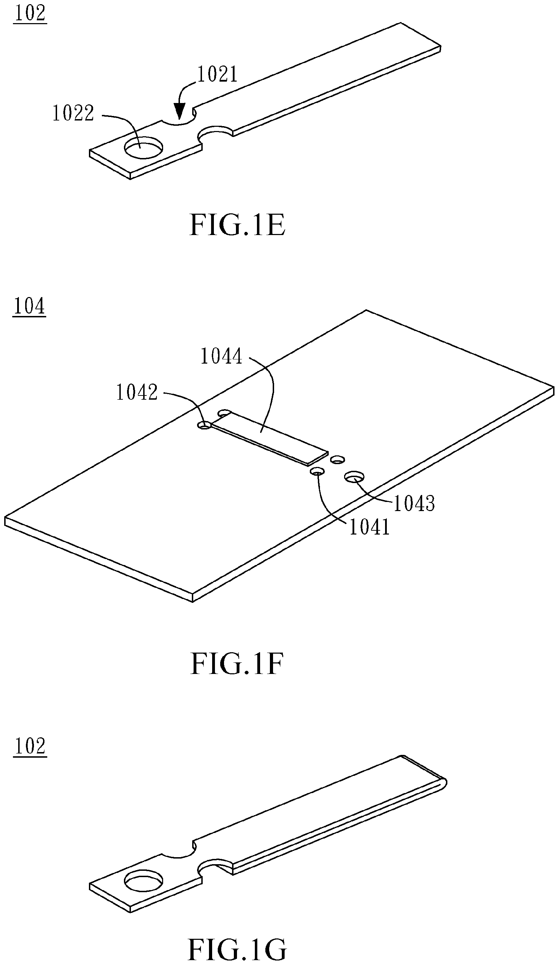

FIG. 1E shows a perspective view of the conductive connector 102 according to the first embodiment of the present invention. Referring to FIG. 1B and FIG. 1E, the conductive connector 102 of the embodiment presses on the transducer plate 103. The conductive connector 102 has one end held between the two first alignment pins 1011, and another end held between the two second alignment pins 1012. Further, two sides of the conductive connector 102 have reentrant curves 1021 respectively, which facilitate holding of the conductive connector 102 between the two first alignment pins 1011.

Further, the bottom cover 101 of the embodiment may include a third alignment pin 1013, which is adjacent to the first alignment pins 1011 but opposite to the other end of the conductive connector 102. The conductive connector 102 is held by the two first alignment pins 1011. Moreover, the conductive connector 102 of the embodiment has a hole 1022 at one end, and the third alignment pin 1013 may pass through the hole 1022.

FIG. 1F shows a perspective view of a bottom surface of the top cover 104 according to the first embodiment of the present invention. The top cover 104 includes at least one pair of first alignment holes 1041 disposed corresponding to the two first alignment pins 1011 of the bottom cover 101; and the top cover 104 also includes at least one pair of second alignment holes 1042 disposed corresponding to the two second alignment pins 1012 of the bottom cover 101. The top cover 104 may further include at least one third alignment hole 1043 disposed corresponding to the third alignment pin 1013 of the bottom cover 101.

The thickness of the conductive connector 102 in the embodiment may be properly determined to adjust the distance between the transducer plate 103 and the bottom cover 101, or between the transducer plate 103 and the top cover 104. Accordingly, the transducer plate 103, while be driven by the driving module 11, will not slap the bottom cover 101 or the top cover 104 to produce noise. FIG. 1G shows a perspective view of another conductive connector 102 according to the first embodiment of the present invention. The conductive connector 102 of the embodiment is folded into two (or more) layers to effectively increase its thickness such that the transducer plate 103 can be prevented from slapping the bottom cover 101 or the top cover 104. In the embodiment, a protrusion 1014 and 1044 (FIG. 1B or FIG. 1F) may be disposed, corresponding to the conductive connector 102, on the bottom cover 101 or the top cover 104 such that the transducer plate 103 can be prevented from slapping the bottom cover 101 or the top cover 104.

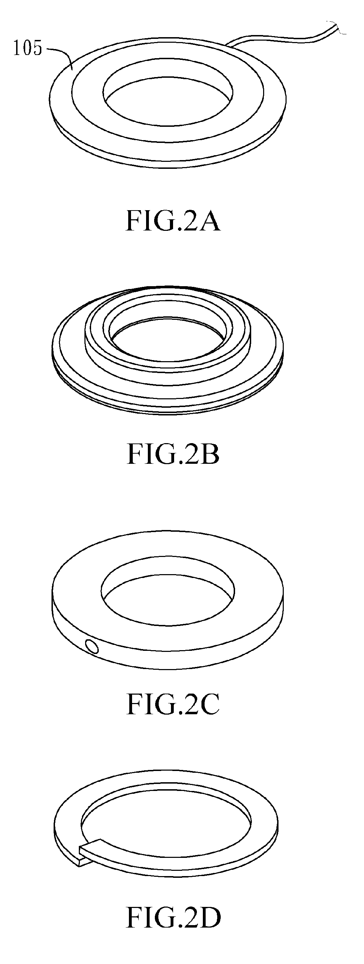

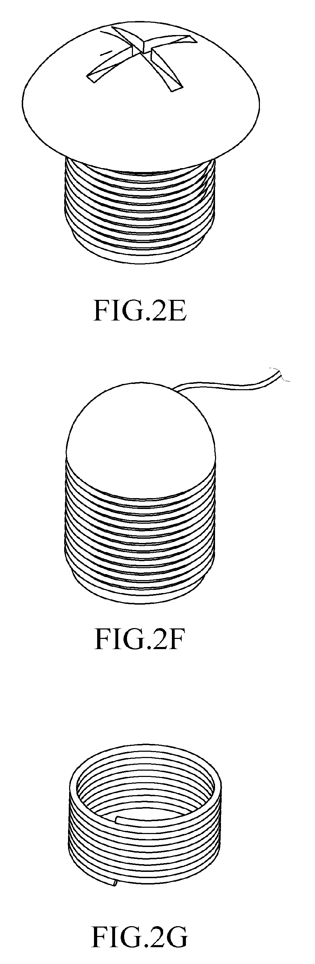

The positive electrode and the negative electrode of the embodiment may be connected to the driving module 11 according to the following schemes. The first electrode connecting scheme adopts soldering technique by applying solder on the conductive connectors 102 to make them electrically connected, and applying solder on the ledge 1031B of the transducer plates 103 to make them electrically connected. The second electrode connecting scheme uses conductive ring 105, as shown in FIG. 2A, which is attached to the third alignment pin 1013 and is electrically connected with the conductive connectors 102, such that the conductivity of the first electrode layer 1033 may thus be derived. The conductive ring 105 of the embodiment is not restricted to that shown in FIG. 2A, but may be properly modified as exemplified in FIG. 2B, FIG. 2C, or FIG. 2D. The third electrode connecting scheme uses the third alignment pin 1013 with conductivity, or, in other words, a conductive third alignment pin 1013. For example, FIG. 2E shows a screw, which may pass through the third alignment hole 1043 of the top cover 104 and then screws into a screw hole in the third alignment pin 1013. The conductive third alignment pin 1013 may be a screw pin as shown in FIG. 2F, or a screw spring as shown in FIG. 2G.

According to the first embodiment as discussed above, the conductive connector 102 may act as a fixing point for the transducer plate 103, and a vibration pivot point for the transducer plate 103 while being driven. When the transducer plate 103 vibrates after being driven by the driving module 11, an inertial force is generated at (the pivot/fixing point) of the conductive connector 102, and the inertial force is then propagated to the bottom cover 101 and the vibration plate to produce sound. Further, after the vibration module 10 has been assembled, the conductive connector 102 may further fix the transducer plate 103.

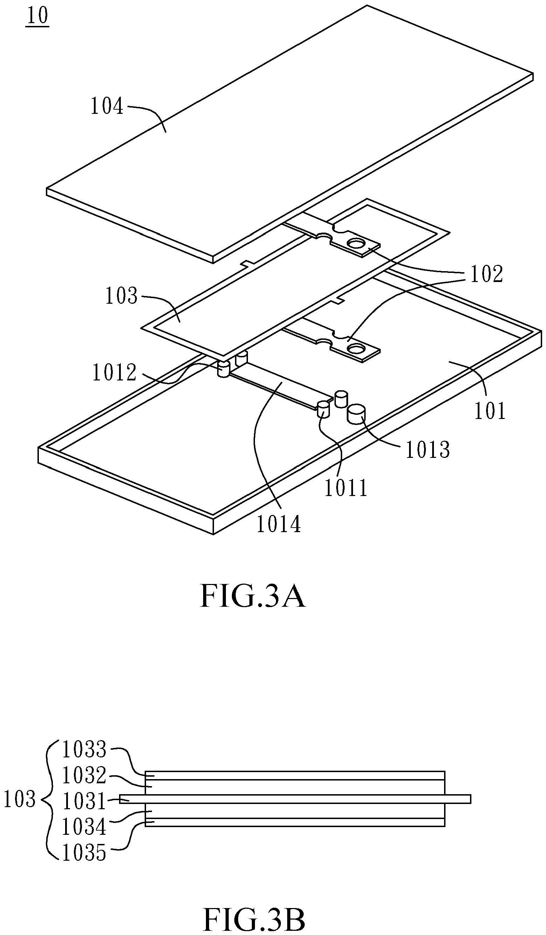

FIG. 3A shows a disassembled vibration module according to a second embodiment of the present invention. The vibration module of the second embodiment is similar to the first embodiment (FIG. 1B), with the exception that the transducer plate 103 of the present embodiment uses a single bimorph transducer. FIG. 3B shows a cross-sectional view of the bimorph transducer according to the second embodiment of the present invention. The transducer plate 103 of the embodiment includes a conductive plate 1031, a first smart material layer 1032 coated on a first (top) surface of the conductive plate 1031, and a first electrode layer 1033 formed on the first smart material layer 1032. Further, the transducer plate 103 of the embodiment also includes a second smart material layer 1034 coated on a second (bottom) surface of the conductive plate 1031, and a second electrode layer 1035 formed below the second smart material layer 1034. The embodiment includes two conductive connectors 102 that are disposed above and below the transducer plate 103, respectively, to contact the first electrode layer 1033 and the second electrode layer 1035, respectively.

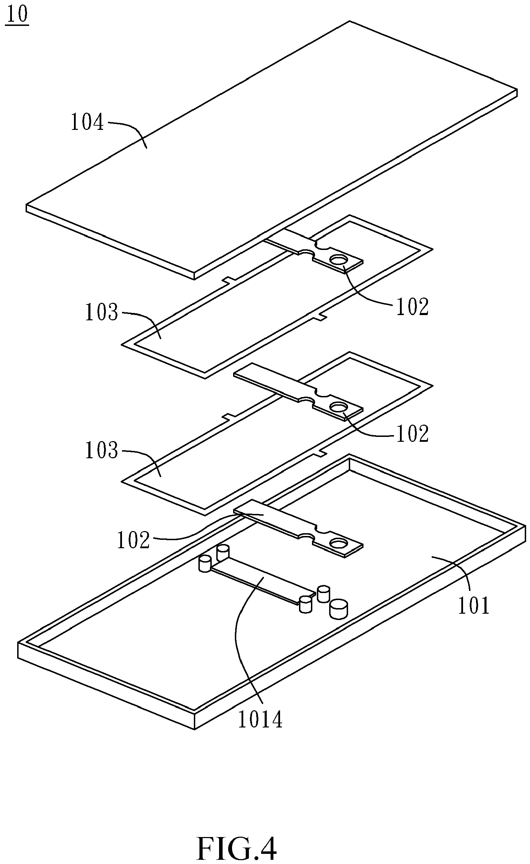

FIG. 4 shows a perspective view of a disassembled vibration module 10 according to a third embodiment of the present invention. The present embodiment is similar to the second embodiment, with the exception that the present embodiment uses two (or more) bimorph transducers as the transducer plates 103 that are (vertically) stacked up; and at least one conductive connector 102 is disposed above or below adjacent transducer plate 103, or between neighboring transducer plates 103. The embodiment may adopt a plurality of conductive rings 105 (FIG. 2A), which are attached to the third alignment pin 1013, and each of which is disposed between neighboring conductive connectors 102 to make the conductive connectors 102 electrically connected.

The embodiment may adopt the conductive connector 102 as shown in FIG. 1G, which is folded into two (or more) layers to effectively increase its thickness.

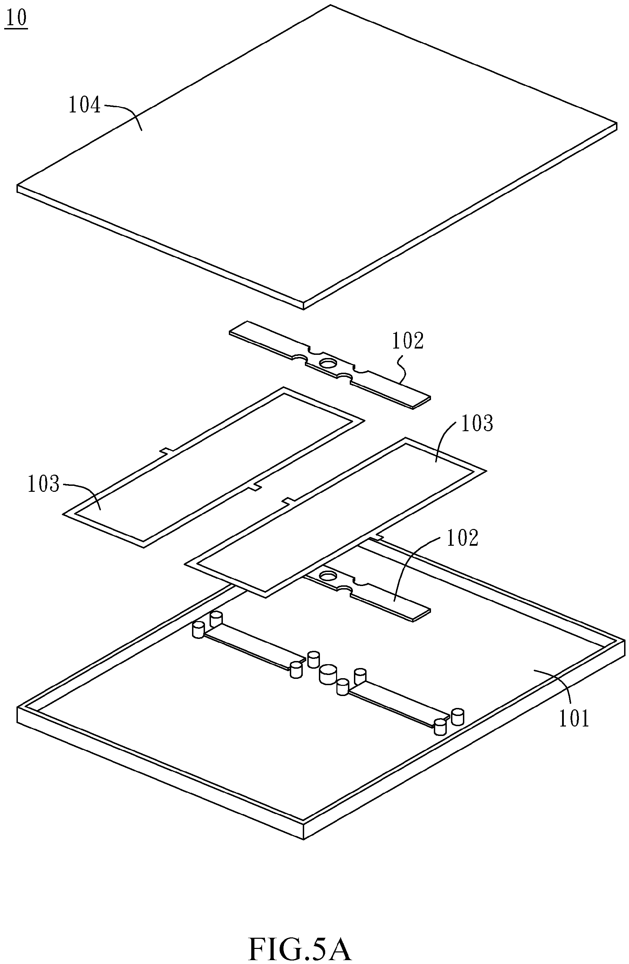

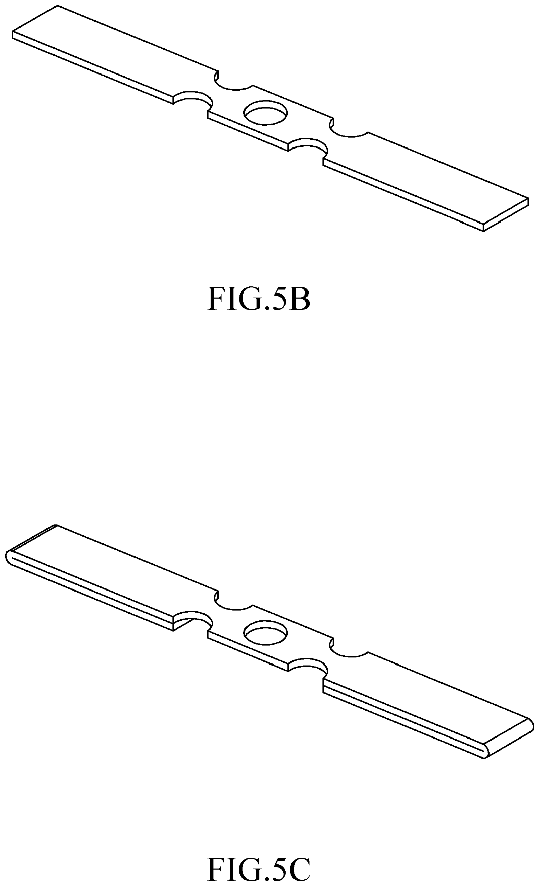

FIG. 5A shows a perspective view of a disassembled vibration module 10 according to a fourth embodiment of the present invention. The present embodiment is similar to the second embodiment, with the exception that the present embodiment uses two (or more) bimorph transducers that are (horizontally) aligned in parallel, and the conductive connectors 102 are disposed above and below the transducer plates 103. In the embodiment, a third alignment pin 1013 may be shared with two (horizontally) adjacently aligned transducer plates 103. Accordingly, two original conductive connectors 102 may be integrated to a single conductive connector 102, as shown in FIG. 5B. The embodiment may adopt the conductive rings 105 (FIG. 2A), which is attached to the third alignment pin 1013, and is electrically connected to the conductive connector 102. The embodiment may adopt the conductive connector 102 as shown in FIG. 1G, which is folded into two (or more) layers, as shown in FIG. 5C, to effectively increase its thickness.

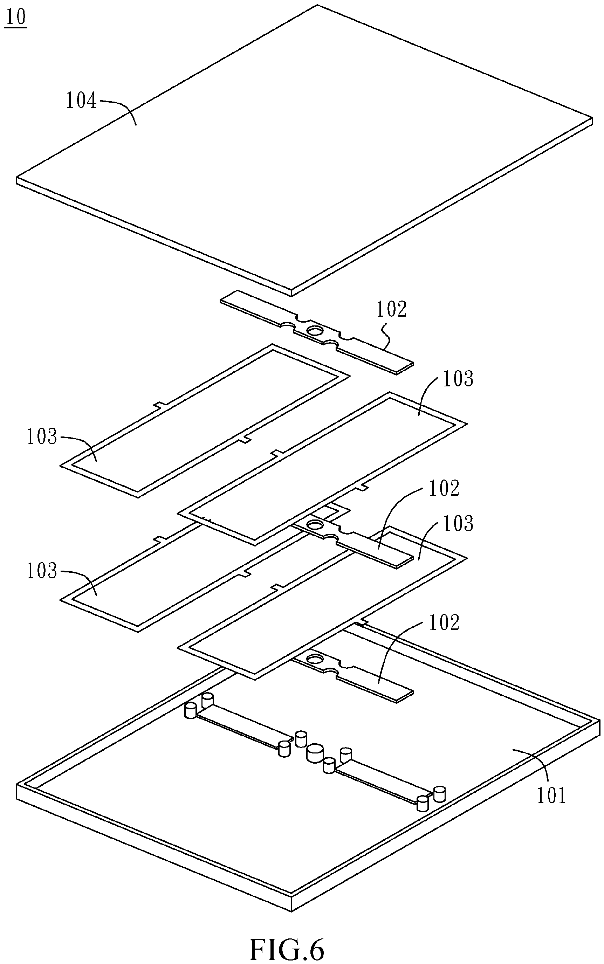

The embodiments discussed above may be individually used or be used in combination. As shown in FIG. 6, the third embodiment (FIG. 4) and the fourth embodiment (FIG. 5A) are used in combination, that is, two (or more) transducer plates 103 that are (vertically) stacked up, and two (or more) transducer plates 103 that are (horizontally) aligned in parallel.

Although specific embodiments have been illustrated and described, it will be appreciated by those skilled in the art that various modifications may be made without departing from the scope of the present invention, which is intended to be limited solely by the appended claims.

## Claims

1. A vibration speaker, comprising:
a top cover;
a bottom cover, wherein the top cover and the bottom cover define a space;
at least one transducer plate, disposed in the defined space, wherein each of the transducer plate comprises a conductive plate, a first smart material layer coated on a first surface of the conductive plate, and a first electrode layer formed on the first smart material layer; and
at least one conductive connector pressing on the transducer plate, wherein an insulating layer is coated on an area between the first surface and the conductive connector but excluding the first electrode layer, such that the conductive connector electrically contacts the first electrode layer but is insulated from the conductive plate.

2. The vibration speaker of claim 1, further comprising a driving module that is electrically connected with the conductive plate and the conductive connector to drive the transducer plate.

3. The vibration speaker of claim 1, wherein the first smart material layer comprises a piezoelectric material, an electro-active polymer (EAP), a shape memory alloy (SMA), a magnetostrictive material or an electrostrictive material.

4. The vibration speaker of claim 1, wherein the at least one transducer plate comprises a single unimorph transducer.

5. The vibration speaker of claim 1, wherein the at least one transducer plate comprises a single bimorph transducer, wherein the bimorph transducer further comprises a second smart material layer coated on a second surface of the conductive layer, and a second electrode layer formed below the second smart material layer; wherein the vibration speaker comprises two said conductive connectors that are disposed above and below the transducer plate respectively, and contact the first electrode layer and the second electrode layer respectively.

6. The vibration speaker of claim 1, wherein the at least one transducer plate comprises at least two bimorph transducers that are stacked up, and at least one said conductive connector is disposed above or below the adjacent transducer plate, or between the neighboring transducer plates.

7. The vibration speaker of claim 1, wherein the at least one transducer plate comprises at least two bimorph transducers that are aligned in parallel, and the conductive connectors are disposed above and below the transducer plates.

8. The vibration speaker of claim 2, wherein the bottom cover comprises:
two first alignment pins contacting one end of the transducer plate; and
two second alignment pins contacting another end of the transducer plate;
wherein the first alignment pins are opposite to the second alignment pins.

9. The vibration speaker of claim 8, wherein the transducer plate comprises at least one ledge extended from a center of one side of the transducer plate, wherein the ledge is held between the two first alignment pins, or between the two second alignment pins.

10. The vibration speaker of claim 9, wherein the two first alignment pins contact one end of the transducer plate, and the two second alignment pins contact another end of the transducer plate.

11. The vibration speaker of claim 10, wherein two sides of the conductive connector have reentrant curves respectively, which facilitate holding of the conductive connector between the two first alignment pins.

12. The vibration speaker of claim 8, wherein the bottom cover comprises a third alignment pin, which is adjacent to the first alignment pins but opposite to the other end of the conductive connector, wherein the conductive connector is held by the two first alignment pins, and the conductive connector has a hole at one end that attaches to the third alignment pin.

13. The vibration speaker of claim 8, wherein the top cover comprises:
at least one pair of first alignment holes disposed corresponding to the two first alignment pins of the bottom cover; and
at least one pair of second alignment holes disposed corresponding to the two second alignment pins of the bottom cover.

14. The vibration speaker of claim 12, wherein the top cover comprises at least one third alignment hole disposed corresponding to the third alignment pin of the bottom cover.

15. The vibration speaker of claim 14, wherein the third alignment pin has a screw hole, a screw passing through the third alignment hole of the top cover and then screws into the screw hole.

16. The vibration speaker of claim 15, further comprising a conductive ring that attaches to the third alignment pin.

17. The vibration speaker of claim 15, wherein the third alignment pin is electrically conductive.

18. The vibration speaker of claim 2, further comprising a protrusion disposed, corresponding to the conductive connector, on the bottom cover or the top cover.
